# EUROPÄISCHE PATENTSCHRIFT

(11) **EP 1 497 861 B1**
(45) Veröffentlichungstag und Bekanntmachung des Hinweises auf die Patenterteilung: **16.05.2007**
(21) Anmeldenummer: 03724840.8
(22) Anmeldetag: 24.03.2003
(51) Int. Cl.: H01L 23/522

(54) **HALBLEITERBAUELEMENT MIT INTEGRIERTER KAPAZITÄTSSTRUKTUR UND VERFAHREN ZU DESSENHERSTELLUNG**
SEMICONDUCTOR COMPONENT HAVING AN INTEGRATED CAPACITANCE STRUCTURE AND METHOD FOR PRODUCING THE SAME
COMPOSANT A SEMI-CONDUCTEUR A STRUCTURE DE CAPACITE INTEGREE ET PROCEDE PERMETTANT DE LE PRODUIRE

(30) Priorität: 19.04.2002 DE 10217567
(43) Veröffentlichungstag der Anmeldung: 19.01.2005
(73) Patentinhaber: Infineon Technologies AG, 81669 München (DE)
(72) Erfinder: BENETIK, Thomas, 80337 München (DE); RUDERER, Erwin, 85570 Markt Schwaben (DE)
(74) Vertreter: Graf Lambsdorff, Matthias
(86) Internationale Anmeldenummer: PCT/DE2003/000964
(87) Internationale Veröffentlichungsnummer: WO 2003/090280

(56) Entgegenhaltungen:
- WO-A-01/91144
- WO-A-01/99163
- DE-A- 10 046 910
- DE-C- 19 850 915
- US-A- 5 208 725
- US-A- 5 583 359
- US-A- 6 037 621
- US-B1- 6 297 524
- APARICIO R ET AL: "Capacity limits and matching properties of integrated capacitors" PROCEEDINGS OF THE IEEE 2001 CUSTOM INTEGRATED CIRCUITS CONFERENCE, SAN DIEGO, CA, USA, 6-9 MAY 2001, Bd. 37, Nr. 3, Seiten 384-393, XP002252607 IEEE Journal of Solid-State Circuits, March 2002, IEEE, USA ISSN: 0018-9200 in der Anmeldung erwähnt

## Beschreibung

Die vorliegende Erfindung betrifft ein Halbleiterbauelement mit einem Halbleitersubstrat auf dem eine Isolationsschicht ausgebildet ist, wobei in der Isolationsschicht eine Kapazitätsstruktur ausgebildet ist. Des weiteren betrifft die Erfindung ein Verfahren zu dessen Herstellung.

In den meisten analogen Schaltungsteilen gemischt digitalanaloger Schaltungen werden Kondensatoren mit hohem Kapazitätswert, großer Linearität und hoher Güte benötigt. Um die Kosten der Herstellung des Bauelements möglichst gering zu halten, ist es erforderlich, dass die Herstellung der Kapazitätsstrukturen möglichst wenig Prozessschritte erfordern. Des Weiteren ist mit der fortschreitenden Miniaturisierung der Bauelemente und integrierten Schaltungen auch die Forderung nach möglichst wenig Flächenbedarf für die Kapazitätsstruktur einhergehend. Eine im Stand der Technik bekannte Kapazitätsstruktur ist aus der Patentschrift DE 198 50 915 C1 bekannt. Eine als sogenannte Sandwich-Kapazität ausgebildete Struktur weist zwei auf einem Halbleitersubstrat aufgebrachte und durch eine dielektrische Schicht voneinander getrennte leitende Beläge auf. Der auf der dielektrischen Schicht aufliegende obere Belag ist über mindestens eine leitende Luftbrücke mit mindestens einem von zwei Anschlussleitern der Kapazität verbunden. Parasitäre Induktivitäten der Kapazität werden weitgehend dadurch kompensiert, dass die beiden Anschlussleiter durch mindestens eine, die Kapazität überbrückende, hochohmige Leitung miteinander verbunden sind.

Aus der Patentschrift US 5,583,359 ist eine Kapazitätsstruktur für einen integrierten Schaltkreis bekannt. Dort wird eine Mehrzahl an Metallplatten, welche die Elektroden eines Stapelkondensators bilden, durch dielektrische Schichten getrennt, übereinander angeordnet. In jeder Ebene einer Metallplatte ist eine von der jeweiligen Platte isolierte Metalleitung angeordnet. Die Metalleitungen sind jeweils von beiden Seiten mit Via-Verbindungen kontaktiert, wodurch zum einen alle ungeradzahlig und zum anderen alle geradzahlig in dem Stapel positionierten Platten elektrisch miteinander verbunden werden. Indem die geradzahlig positionierten Platten an eine erste Anschlussleitung und die ungeradzahlig positionierten Platten an eine zweite Anschlussleitung angelegt werden, weisen benachbarte Platten unterschiedliches Potenzial auf und bilden jeweils paarweise Elektroden eines Plattenkondensators. Die Kapazitätsoberfläche wird somit durch die Plattenoberflächen gebildet. Eine alternative Ausführung der Elektroden ist dadurch gegeben, dass die Platten als streifenförmige Leitungen, die parallel zueinander angeordnet sind, ausgebildet sind.

Eine ähnliche Ausbildung einer Kapazitätsstruktur ist aus der Patentschrift US 5,208,725 bekannt. Auf einem Halbleitersubstrat wird eine Mehrzahl erster streifenförmig ausgebildeter Leitungen parallel zueinander angeordnet. Durch eine dielektrische Schicht getrennt, wird deckungsgleich auf diese ersten Leitungen eine Mehrzahl an zweiten Leitungen angeordnet. Indem vertikal und lateral benachbarte Leitungen auf verschiedenem Potenzial liegen, werden sowohl Kapazitäten zwischen übereinander liegenden Leitungen als auch Kapazitäten zwischen benachbarten Leitungen in einer Ebene erzeugt.

Eine weitere Kapazitätsstruktur ist in Aparicio, R. und Hajimiri, A.: Capacity Limits and Matching Properties of Lateral Flux Integrated Capacitors; IEEE Custom Integrated Circuits Conference, San Diego May 6 - 9, 2001, bekannt. Senkrecht angeordnete Stabstrukturen werden symmetrisch zueinander angeordnet. Jeder der Stäbe wird aus Metallbereichen und Via-Bereichen, die abwechselnd aufeinander angeordnet sind aufgebaut. Die Metallflecken eines Stabes sind auf ein gemeinsames Potenzial gelegt. Metallflecken benachbarter Stäbe weisen unterschiedliches Potenzial auf. Die Via-Bereiche kontaktieren jeweils zwei benachbarte Metallbereiche eines Stabes. Die Kapazitätsdichte ist durch die minimale Größe der Metallbereiche in den Stäben begrenzt. Die Größe dieser Metallbereiche ist jedoch deutlich größer als die Größer der Via-Bereiche in den Stäben, was daran liegt, dass an Masken für die Herstellung der Metallbereiche andere Anforderungen gestellt werden als an Masken mit denen die Via-Bereiche hergestellt werden. Aufgrund der erforderlichen Mindestgröße der Metallbereiche weisen die Stäbe ebenfalls eine Mindestgröße auf, wodurch die Kapazitätsdichte in dieser Kapazitätsstruktur im Hinblick auf die Miniaturisierung der Bauelemente und der Reduzierung des benötigten Platzbedarfs der Kapazitätsstruktur beschränkt ist.

Aus der Druckschrift WO0199163 ist eine Kapazitätsstruktur bekannt, die vertikal ineinandergreifende Elektroden aufweist. Diese Elektroden werden durch übereinander gestapelte Metallflecken gebildet, zwischen denen sich Isolierlagen befinden und die durch leitende Vias vertikal miteinander verbunden sind.

Ein Nachteil bei eigens einem Halbleiterbauelement prozessierten Kapazitätsstrukturen - wie dies in gegenwärtigen Prozessen oftmals der Fall ist -, ist deren aufwändige Herstellung. Insbesondere wenn eine derartige Kapazitätsstruktur als Plattenkondensator aus zwei zusätzlichen Metallisierungslagen, welche in dem Bauelement oder der Schaltung keine weitere Verwendung haben, ausgebildet ist, ist die Herstellung schwieriger und kostenintensiver. Weiterhin ist es besonders bei den Sandwich-Kapazitätsstrukturen nachteilig, dass sie die von ihnen auf dem Chip beanspruchte Fläche nur sehr ineffizient ausnutzen und gemessen an der benötigten Fläche einen relativ geringen Kapazitätswert zur Nutzkapazität liefern und damit zusammenhängend einen relativ hohen parasitären Kapazitätsanteil zum Halbleitersubstrat aufweisen. Aufgrund dieses relativ hohen parasitären Kapazitätsanteils ist die Nutzkapazität der Sandwich-Kapazitäten nur beschränkt zu vergrößern.

Es ist daher Aufgabe der vorliegenden Erfindung, ein Halbleiterbauelement mit einer integrierten Kapazitätsstruktur und ein Verfahren zu dessen Herstellung zu schaffen, welches einfach erzeugt werden kann und mit dem das Verhältnis von Nutzkapazität zu parasitärer Kapazität verbessert werden kann.

Diese Aufgabe wird durch ein Halbleiterbauelement, welches die Merkmale des Patentanspruchs 1 aufweist, sowie durch ein Verfahren das die Schritte nach Patentanspruch 15 aufweist, gelöst.

Ein Halbleiterbauelement weist ein Halbleitersubstrat auf, auf dem ein Schichtensystem aus einer oder mehreren Isolationsschichten angeordnet ist. In dieser Isolationsschicht oder in diesem Isolationsschichten-System ist eine Kapazitätsstruktur ausgebildet. Ein erster Teil einer Kapazitätsoberfläche der Kapazitätsstruktur wird durch Teile der Oberflächen von mindestens zwei Metallisierungsebenen gebildet. Die Metallisierungsebenen sind parallel zueinander und parallel zum Halbleitersubstrat angeordnet und sind jeweils mit einer Anschlussleitung elektrisch verbunden.

Ein wesentlicher Gedanke der Erfindung liegt darin, dass die Kapazitätsstruktur mindestens einen elektrisch leitenden Bereich aufweist, welcher zwischen den Metallisierungsebenen angeordnet ist und in dem Isolationsschichten-System ausgebildet ist. Neben dem ersten Kapazitätsoberflächenbereich weist die Kapazitäststruktur dadurch einen zweiten Kapazitätsoberflächenbereich auf, durch den die gesamte Kapazitätsoberfläche vergrößert ist. Dieser elektrisch leitende Bereich ist nur mit einer der Metallisierungsebenen elektrisch verbunden.

Dadurch kann eine Kapazitätsstruktur ausgebildet werden, die mit relativ einfach hergestellt werden kann und des Weiteren das Verhältnis von Nutzkapazität der Kapazitätsstruktur zur parasitären Kapazität verbessert. Ein weiterer Vorteil ist dadurch gegeben, dass durch die Anordnung des elektrisch leitenden Bereichs der horizontale Flächenbedarf der gesamten Kapazitätsstruktur nahezu nicht vergrößert wird und dadurch auch das Verhältnis von Nutzkapazität zu benötigter Chipfläche wesentlich verbessert wird.

Eine vorteilhafte Ausgestaltung der Erfindung sieht vor, den elektrisch leitenden Bereich als homogene, zusammenhängende Erhebung auszubilden. Besonders vorteilhaft ist es, wenn die elektrisch leitenden Bereiche keine derartigen metallischen Gebiete aufweisen, die durch Strukturierung der Metallisierungsebenen erzeugt werden. Dadurch sind die elektrischen Bereiche ohne Zwischenmetallisierungsbereiche - die aus der Strukturierung der Metallisierungsebenen erzeugt werden - ausgebildet. Insbesondere eine homogene Via-Struktur zeichnet sich als besonders vorteilhaft aus. Diese Struktur der Vias ermöglicht besonders im Vergleich zur bekannten Kapazitätsstruktur in Aparicio, R. und Hajimiri, A.: Capacitiy Limits and Matching Properties of Lateral Flux Integrated Capacitors; IEEE Custom Integrated Circuits Conference, San Diego May 6 - 9, 2001, die Realisierung einer wesentlich kleineren Struktur als die dort offenbarte gestapelte Struktur aus Zwischenmetallisierungs- und Via-Bereichen. Besonders in einem sogenannten Dual-Damescene-Prozess können in einem Prozessschritt homogene Vias ausgebildet werden, wodurch diese Strukturen mit hoher Dichte aneinandergereiht werden können und die Kapazitätsoberfläche der Elektroden bei nahezu gleichbleibendem horizontalen Flächenbedarf wesentlich vergrößert werden kann. Beim Dual-Damescene werden dabei nicht mehrere (übereinanderliegende) Vias gleichzeitig gefertigt, sondern jeweils gleichzeitig eine Via-Metall-Lage. Bei modernen Dual-Damescene-Prozessen werden Loch- bzw. Grabenstrukturen der zu fertigenden Vias und der Metallbahnen nacheinander geätzt und nachfolgend gleichzeitig mit einem Metall, bspw. Kupfer, aufgefüllt. Die Strukturierung insbesondere der dielektrischen Schicht einer Kapazitätsstruktur, zur Erzeugung der Vias, welche komplett durch die dielektrische Schicht hindurchreichen, kann durch einen Lithographieschritt (Via-Lithographie) hergestellt werden. Durch einen nachfolgenden Via-Ätzschritt wird die erwünschte Via-Struktur in die dielektrische Schicht geätzt. Im Vergleich zu Prozessen, bei denen die durch die dielektrische Schicht hindurchreichenden Vias durch eine Via- und eine Metall-Masken-Ätzung (welche zur Erzeugung von Grabenbereichen für Metallbahnen verwendet wird) erzeugt werden, kann dadurch einerseits eine größerer Genauigkeit der Kapazität erreicht werden, da Ungenauigkeiten in der Justage von Metall-Masken in diesem Fall die Ausbildung der Kapazität nicht beeinflussen. Des Weiteren ist es mit Metall-Masken, welche für Linienformen ausgelegt sind, nicht möglich gleichzeitig punktartige Strukturen zu erzeugen. Dies ist deshalb der Fall, da Masken, welche zur Erzeugung punktartiger Strukturen ausgelegt sind, für die Lochebenen aufgrund der zweidimensionalen Beugungseffekte eine wesentlich höhere Belichtungsintensität benötigen, um eine entsprechende Struktur auszubilden, wodurch Lochmasken eine fest vorgegebene Lochgröße haben. Für die Erzeugung der punktartigen Strukturen würde eine zusätzliche Miteinbeziehung von Metall-linienförmigen Löchern (Langlöchern) bedeuten, dass nur in einer Dimension minimale Abstände zur Erzeugung der Kapazität vorteilhaft genützt werden können. Wie in der Erfindung vorteilhaft ausgeführt, können durch Vermeidung der Ausbildung von Langlöchern ausschließlich Vias erzeugt werden, die in beiden Dimensionen minimale Abstände aufweisen und welche für alternierende Kondensatorflächen verwendet werden können.

Weiterhin ist es vorteilhaft, den elektrisch leitenden Bereich im wesentlichen senkrecht zu den Metallisierungsebenen anzuordnen. Dadurch kann die Oberfläche des elektrisch leitenden Bereichs möglichst groß gestaltet werden und dadurch ein möglichst großer Beitrag zur Nutzkapazität erzielt werden.

In einem bevorzugten Ausführungsbeispiel sind die beiden Metallisieriingsebenen jeweils als homogene Platten ausgebildet. Jeder der beiden Platten ist mit zumindest einem elektrisch leitenden Bereich elektrisch verbunden. Es kann vorgesehen sein, die elektrisch leitenden Bereiche als stabförmig auszubilden. Weiterhin kann vorgesehen sein, eine Mehrzahl an ersten stabförmig ausgebildeten Bereichen an der ersten Metallisierungsebene anzuordnen, die sich in Richtung zur zweiten Metallisierungsebene hin erstrecken. Die Stäbe sind mit einem im wesentlichen festen Abstand zueinander an der ersten Metallisierungsebene angeordnet. Eine Mehrzahl an zweiten stabförmig ausgebildeten Bereiche ist ebenfalls mit einem im wesentlichen festen Abstand zueinander an der zweiten Metallisierungsebene angeordnet. Vorteilhafter Weise erstrecken sich diese zweiten stabförmig ausgebildeten elektrisch leitenden Bereiche zwischen den ersten stabförmigen Bereichen in Richtung zur ersten Metallisierungsebene. Die elektrisch leitenden Bereiche der beiden Metallisierungsebenen sind somit versetzt zueinander angeordnet, wodurch in vertikaler Richtung betrachtet stets ein erster elektrisch leitender, stabförmiger Bereich der Oberfläche der zweiten Metallisierungsebene gegenüberliegt und ein zweiter elektrisch leitender, stabförmiger Bereich der Oberfläche der zweiten Metallisierungsebene gegenüberliegt.

Besonders vorteilhaft ist es, die ersten stabförmigen Bereiche mit einer ersten Länge L₁ und die zweiten stabförmigen Bereiche mit einer Länge L₂ auszubilden, wobei die Summe der Längen L₁ und L₂ größer als der Abstand, den die beiden Metallisierungsebenen zueinander aufweisen, ist. Dadurch werden die ersten und die zweiten stabförmigen Bereiche -quasi miteinander verzahnt. Dadurch stehen sich Bereiche der Seitenflächen der ersten stabförmigen Bereiche und Bereiche der Seitenfläche der zweiten stabförmigen Bereiche gegenüber, wodurch ein zusätzlicher Anteil zur gesamten Kapazitätsoberfläche erzeugt wird und die Nutzkapazität erhöht werden kann.

In einem weiteren vorteilhaften Ausführungsbeispiel weist die Kapazitätsstruktur zwei Metallisierungsebenen auf, die beide aus mehreren parallel zueinander angeordneten Leitungen bestehen. Die Leitungen, welche die erste Metallisierungsebene bilden, sind deckungsgleich zu den Leitungen, welche die zweite Metallisierungsebene bilden, angeordnet. Es kann vorgesehen sein, auf jeder der Leitungen einen elektrisch leitenden Bereich anzuordnen. Vorteilhaft ist es, die elektrisch leitenden Bereiche stabförmig auszubilden und so auf den Leitungen anzuordnen, dass sie sich jeweils in Richtung der deckungsgleich gegenüberliegenden Leitung der anderen Metallisierungsebene hin erstrecken. Bevorzugt ist es, auf jeder der ersten Leitungen jeweils im im wesentlichen festen Abstand zueinander mehrere stabförmig ausgebildete elektrisch leitenden Bereich anzuordnen. Auf den zweiten Leitungen werden ebenfalls jeweils mehrere stabförmig ausgebildete Bereiche mit einem im wesentlichen festen Abstand zueinander angeordnet. Die stabförmigen Bereiche der zweiten Leitungen werden auch hier so angeordnet, dass sie sich zwischen den stabförmigen Bereichen der ersten Leitungen in Richtung zu den ersten Leitungen hin erstrecken. Ebenso kann auch in dieser Ausführung eine quasi verzahnte Struktur der ersten und zweiten stabförmigen Bereiche der ersten bzw. der zweiten Leitungen erreicht werden, wenn die Längenverhältnisse L₁ und L₂ entsprechend der oben erläuterten ersten Ausführung gewählt werden. Dadurch können die gleichen Vorteile erzielt werden.

Ein weitere bevorzugte Ausführungsform kennzeichnet sich durch zwei Metallisierungsebenen, von denen die erste als homogenen Platte und die zweite als gitterähnliche Struktur ausgebildet ist. Zumindest ein stabförmig ausgebildeter, elektrisch leitender Bereich ist auf der als homogene Platte ausgebildeten ersten Metallisierungsebene derart angebracht, dass er sich in Richtung der Gitterebene erstreckt. Besonders vorteilhaft ist es, wenn sich der stabförmige Bereich zumindest teilweise in eine der Aussparungen der Gitterstruktur der zweiten Metallisierungsebene hinein erstreckt. Dadurch kann die Kapazitätsoberfläche erhöht werden und der Anteil der Nutzkapazität vergrößert werden.

In einem weiteren Ausführungsbeispiel ist zusätzlich zu den beiden Metallisierungsebenen der vorhergehenden Ausführungsform eine dritte Metallisierungsebene vorhanden, welche ebenfalls in Form eines Gitters ausgeführt ist und parallel und beabstandet zur ersten Gitterebene auf dieser angeordnet ist. Die beiden Gitterebenen sind mittels elektrischer Verbindungen miteinander kontaktiert. Der zumindest eine stabförmige elektrisch leitende Bereich ist derart ausgebildet, dass er durch eine Aussparung der ersten Gitterebene hindurch ragt und sich zumindest teilweise in eine Aussparung der zweiten Gitterebene bzw. der dritten Metallisierungsebene hinein erstreckt. Dadurch kann eine weitere Vergrößerung der Kapazitätsoberfläche und der Nutzkapazität erreicht werden. Der Flächenbedarf der Kapazitätsstruktur kann dabei nahezu gleich gehalten werden.

Ein weiterer Aspekt der Erfindung betrachtet ein Verfahren zum Herstellen eines Halbleiterbauelements mit einer integrierten Kapazitätsstruktur. Die Kapazitätsstruktur wird in einer Isolationsschicht ausgebildet, wobei die Isolationsschicht auf einem Halbleitersubstrat abgeschieden wird. Ein wesentlicher Gedanke ist es, dass zwischen zumindest zwei Metallisierungsebenen, welche die Kapazitätsstruktur aufweist, ein elektrisch leitender Bereich in der Isolationsschicht ausgebildet wird, der nur mit einer der beiden Metallisierungsebenen verbunden wird.

Vorteilhaft ist es, dass der elektrisch leitende Bereich als homogene zusammenhängende Erhebung ausgebildet wird, wobei der elektrisch leitende Bereich ohne ein derartiges metallisches Gebiet ausgebildet wird, welches durch eine Strukturierung einer Metallisierungsebene erzeugbar ist.

Besonders bevorzugt wird der elektrisch leitende Bereich als Via-Struktur ausgebildet.

Das Ausbilden des elektrisch leitenden Bereichs oder der elektrisch leitenden Bereiche als Via-Struktur kann derart durchgeführt werden, dass das Ätzen der Löcher in die Isolationsschicht, aus denen durch nachfolgendes Auffüllen mit einem leitenden Material, bspw. Kupfer oder Wolfram, die Vias erzeugt werden, durch einen Ätzschritt durchgeführt wird. Indem die Löcher ohne eine Kombination aus einem derartigen Ätzschritt und einen Ätzschritt zur Erzeugung von Metallbahnen - deren Bereiche vorab durch Metallmasken definiert werden - erzeugt werden, kann eine hohe Kapazitätsdichte der Kapazitätsstruktur erreicht werden.

Vorteilhafte Ausgestaltungen sind in den Unteransprüchen Angegeben.

Anhand der folgenden schematischen Zeichnungen werden mehrerer Ausführungsbeispiele der Erfindung näher erläutert.
Es zeigen:
- Fig. 1: eine perspektivische Darstellung eines ersten Ausführungsbeispiels eines erfindungsgemäßen Halbleiterbauelements;
- Fig. 2: eine erste Schnittdarstellung des Ausführungsbeispiels gemäß Fig. 1;
- Fig. 3: eine zweite Schnittdarstellung des Ausführungsbeispiels gemäß Fig. 1
- Fig. 4: eine dritte Schnittdarstellung des Ausführungsbeispiels gemäß Fig. 1;
- Fig. 5: eine perspektivische Darstellung eines zweiten Ausführungsbeispiels des erfindungsgemäßen Halbleiterbauelements;
- Fig. 6: eine erste Schnittdarstellung des zweiten Ausführungsbeispiels gemäß Fig. 5;
- Fig. 7: eine zweite Schnittdarstellung des zweiten Ausführungsbeispiels gemäß Fig. 5;
- Fig. 8: eine dritte Schnittdarstellung des zweiten Ausführungsbeispiels gemäß Fig. 5;
- Fig. 9: eine vierte Schnittdarstellung des zweiten Ausführungsbeispiels gemäß Fig. 5 ;
- Fig. 10: eine perspektivische Darstellung eines dritten Ausführungsbeispiels des erfindungsgemäßen Halbleiterbauelements;
- Fig. 11: eine erste Schnittdarstellung des dritten Ausführungsbeispiels gemäß Fig. 10;
- Fig. 12: eine zweite Schnittdarstellung des dritten Ausführungsbeispiels gemäß Fig. 10;
- Fig. 13: eine perspektivische Darstellung eines vierten Ausführungsbeispiels des erfindungsgemäßen Halbleiterbauelements; und
- Fig. 14: eine Schnittdarstellung des vierten Ausführungsbeispiels gemäß Fig. 13;

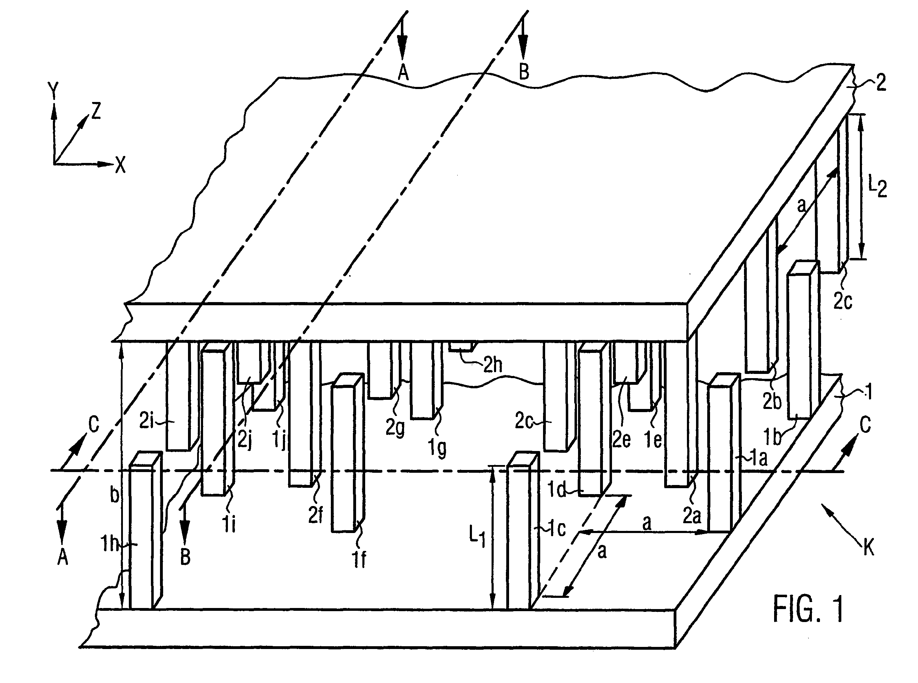

In einem ersten Ausführungsbeispiel weist ein erfindungsgemäßes Halbleiterbauelement (Fig. 1) ein nicht dargestelltes Halbleitersubstrat auf, auf dem eine nicht dargestellte Isolationsschicht aufgebracht ist. Die Isolationsschicht kann auch aus mehreren Schichten bestehen. In dieser Isolationsschicht ist eine Kapazitätsstruktur K integriert. Die Kapazitätsstruktur K weist eine erste Metallisierungsebene 1 auf, die im Ausführungsbeispiel als homogenen Platte ausgeführt ist. Parallel dazu ist eine zweite Metallisierungsebene 2 ausgebildet, welche ebenfalls als homogene, zusammenhängende Platte ausgebildet ist. Die erste Metallisierungsebene 1 ist an eine nicht dargestellte erste Anschlussleitung und die zweite Metallisierungsebene ist an eine nicht dargestellte zweite Anschlussleitung angelegt, wodurch die beiden Metallisierungsebenen 1 und 2 unterschiedliches elektrisches Potenzial aufweisen und Elektroden bilden. Auf der ersten Platte 1 sind mehrere stabförmig ausgebildete, elektrisch leitende Bereiche 1a bis 1j senkrecht zur Platte 1 angeordnet. Die stabförmigen Bereiche 1a bis 1j sind unmittelbar mit der Platte 1 elektrisch verbunden und als homogene, zusammenhängende Vias mit einer einheitlichen Länge L₁ ausgebildet. Die Stäbe 1a bis 1j sind in Richtung zur zweiten Metallisierungsebene 2 ausgerichtet und weisen keine elektrische Verbindung zu dieser auf.

In z-Richtung sind die Stäbe 1a und 1b, die Stäbe 1c, 1d und 1e, die Stäbe 1f und 1g sowie die Stäbe 1h, 1i und 1j jeweils mit einem Abstand a zueinander angeordnet. Die Stäbe 1a, 1b, 1f und 1g sind darüber hinaus um jeweils a/2 in z-Richtung gegenüber den Stäben 1c, 1d, 1e, 1h, 1i und 1j verschoben, so dass in x-Richtung die Stäbe 1f und 1h, die Stäbe 1a und 1f, die Stäbe 1d und 1i, die Stäbe 1b und 1g und die Stäbe 1e und 1j jeweils auf einer Linie liegen.

Ebenso sind an der Platte 2 zweite elektrisch leitende Bereiche 2a bis 2j als homogene Stäbe ausgebildet, die alle eine Länge L₂ aufweisen. Die Stäbe 2a bis 2j werden ebenso mit dem Abstand a auf der Platte 2 angeordnet, werden jedoch derartig auf der Platte 2 positioniert, dass sie sich zwischen den Stäben 1a bis 1j in Richtung der ersten Metallisierungsebene 1 erstrecken. So liegen beispielsweise die Stäbe 2a, 2b und 2c an der gleichen x-Position wie die Stäbe 1a und 1b, sind jedoch in z-Richtung gegeneinander verschoben. Selbiges gilt für die anderen Stäbe 1c bis 1j und 2d bis 2j.

Die Längen L₁ und L₂ der Stäbe 1a bis 2j werden so gewählt, dass sie kleiner sind als der Abstand b der beiden Metallisierungsebenen 1 und 2 zueinander aber die Summe von L₁ und L₂ größer als der Abstand b, den die Metallisierungsbenen 1 und 2 zueinander aufweisen, ist. Dadurch wird erreicht, dass sich Seitenflächenbereiche benachbarter Stäbe, beispielsweise von 1a und 2a, gegenüberliegen und aufgrund des unterschiedlichen elektrischen Potenzials, das diese benachbarten Stäbe aufweisen eine Kapazitätsoberfläche geschaffen wird, deren Kapazität einen Anteil zur Nutzkapazität beiträgt.

Es kann auch vorgesehen sein, dass die Stäbe 1a bis 1j und die Stäbe 2a bis 2j unterschiedliche Längen aufweisen. Wesentlich ist jedoch, dass die Summen der Längen von benachbarten Stäben der ersten und der zweiten Metallisierungsebene jeweils größer ist als der Abstand b der Metallisierungsebenen. Somit ist gewährleistet, dass sich stets Oberflächenbereiche der Seitenflächen der Stäbe 1a bis 1j der ersten Metallisierungsebene 1 und Oberflächenbereiche der Seitenfläche der jeweils benachbarten Stäbe 2a bis 2j der zweiten Metallisierungsebene 2 gegenüberliegen und dadurch eine Kapazitätsoberfläche geschaffen wird, die eine Beitrag zur Nutzkapazität liefert. In dem Ausführungsbeispiel weist die dem Halbleitersubstrat fernere Platte 2 mit den Stäben 1a bis 1j eine minimale parasitäre Kapazität gegenüber dem Halbleitersubstrat auf.

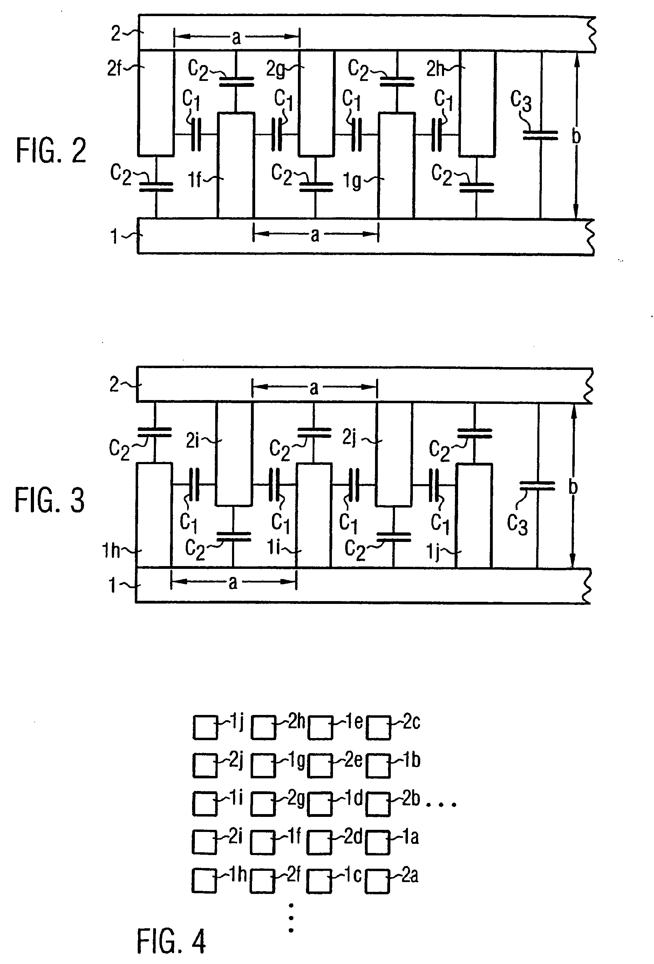

In Fig. 2 ist ein Querschnitt entlang der Linie BB gemäß Fig. 1 dargestellt. Die Platten 1 und 2 weisen die Stäbe 1f und 1g bzw. 2f bis 2h auf, die jeweils den Abstand a zueinander aufweisen. In der Querschnittdarstellung ist die quasi verzahnte Struktur der zueinander versetzten Stäbe 1f und 1g sowie der Stäbe 2f bis 2h zu erkennen. Erste Kapazitätsanteile C₁ als Beitrag zur gesamten Nutzkapazität der Kapazitätsstruktur K (Fig. 1) werden jeweils zwischen den homogenen, als Via-Strukturen ausgebildeten Stäben 1f, 1g und 2f bis 2h erzeugt. Zweite Kapazitätsanteile C₂ als Beitrag zur gesamten Nutzkapazität werden zwischen den Stäben 1f und 1g und der Platte 1 sowie zwischen den Stäben 2f bis 2h und der Platte 2 erzeugt. Ein weiterer Kapazitätsanteil C₃ als Beitrag zur Nutzkapazität wird durch die Platte 1 und die Platte 2 erzeugt.

In Fig. 3 ist eine Querschnittdarstellung der Kapazitätsstruktur K gemäß Fig. 1 entlang der Linie AA aufgezeigt. Die Erzeugung der Beiträge der Kapazitätsanteile C₁, C₂ und C₃ entsprechen den Ausführungen zu Fig. 2.

Eine weitere Schnittdarstellung entlang der Schnittlinie CC in Fig. 1 ist in Fig. 4 dargestellt. In dieser Darstellung ist die symmetrische Anordnung der Stäbe 1a bis 1j und der Stäbe 2a bis 2j an den Platten 1 und 2 zu erkennen. Jeder Stab 1a bis 1j ist zumindest zu zwei Stäben 2a bis 2j benachbart (ebenso ist jeder Stab 2a bis 2j zu mindestens zwei Stäben 1a bis 1j benachbart), wodurch jeweils die hier nicht dargestellten Kapazitätsanteile C₁ erzeugt werden.

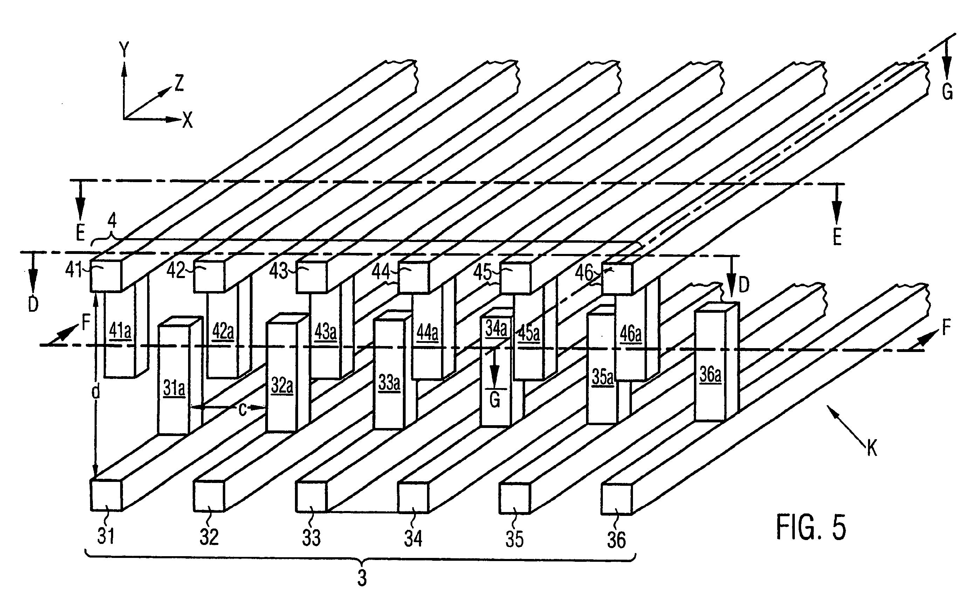

Ein weiteres Ausführungsbeispiel ist in Fig. 5 dargestellt. Die Kapazitätsstruktur K ist ebenso wie im ersten Ausführungsbeispiel in einer nicht dargestellten Isolationsschicht oder einem aus mehreren Schichten bestehenden Isolationsschichten-System ausgebildet, wobei die Isolationsschicht auf einem nicht dargestellten Halbleitersubstrat abgeordnet ist. Die Metallisierungsebenen 3 und 4 sind jeweils aus mehreren parallel zueinander angeordneten Leitungen 31 bis 36 und 41 bis 46 gebildet, wobei die Leitungen 31 bis 36 jeweils deckungsgleich zu den Leitungen 41 bis 46 angeordnet sind. Die Leitungen 31, 33, 35, 42, 44 und 46 sind mit einer nicht dargestellten ersten Anschlussleitung elektrisch verbunden, wodurch diese Leitungen auf ein erstes Potenzial gelegt werden. Die Leitungen 32, 34, 36, 41, 43 und 45 sind mit einer nicht dargestellten zweiten Anschlussleitung elektrisch verbunden, wodurch diese Leitungen auf ein zweites Potenzial gelegt werden. An jeder der Leitungen 31 bis 36 und 41 bis 46 ist jeweils ein homogener, stabförmig ausgebildeter, elektrisch leitender Bereich 31a bis 36a und 41a bis 46a angeordnet und unmittelbar mit der jeweiligen Leitung verbunden. Die Stäbe 31a bis 36a sind senkrecht in Richtung der Leitungen 41 bis 46 ausgerichtet. Ebenso sind die Stäbe 41a bis 46a senkrecht in Richtung der Leitungen 31 bis 36 ausgerichtet.

Die Darstellung der Stäbe 31a bis 36a und 41a bis 46a ist beispielhaft und kann in vielerlei Hinsicht erweitert werde. Beispielsweise kann jede Leitung 31 bis 46 jeweils mehrere weitere Stäbe aufweisen die beispielsweise in einem festen Abstand zueinander auf jeder Leitung 31 bis 46 angeordnet sind. Die Stäbe 31a bis 36a sind auf einer festen ersten Position in z-Richtung und die Stäbe 41a bis 46a sind auf einer festen zweiten Position in z-Richtung angeordnet, wodurch die Stäbe 31a bis 36a in z-Richtung versetzt zu den Stäben 41a bis 46a angeordnet sind. Die Längen der Stäbe 31a bis 36a können eine einheitliche Länge aufweisen oder aber auch unterschiedlich sein. Ebenso können die Stäbe 41a bis 46a einheitliche Länge oder unterschiedlich lang ausgebildet sein. Wesentlich ist auch für dieses Ausführungsbeispiel, dass die Summe der Länge eines Stabes 31a bis 36a plus die Länge eines Stabes 41a bis 46a größer ist als der Abstand d, den jeweils die Leitungen der Metallisierungebenen 3 und 4 zueinander aufweisen. Abhängig von dem Potenzial auf das die Leitungen 31 bis 46 gelegt werden, weisen beispielweise die Leitungen 31, 33, 35, 42, 44 und 46 mit den zugehörigen Stäben 31a, 33a, 35a, 42a, 44a und 46a eine minimale parasitäre Kapazität gegenüber dem Halbleitersubstrat welches unter der Metallisierungsebene 3 angeordnet ist auf. Die Potenziale können auch so gewählt werden, dass die Leitungen 32, 34, 36, 41, 43 und 45 mit den zugehörigen Stäben 32a bis 45 a eine minimale parasitäre Kapazität gegenüber dem Halbleitersubstrat aufweisen.

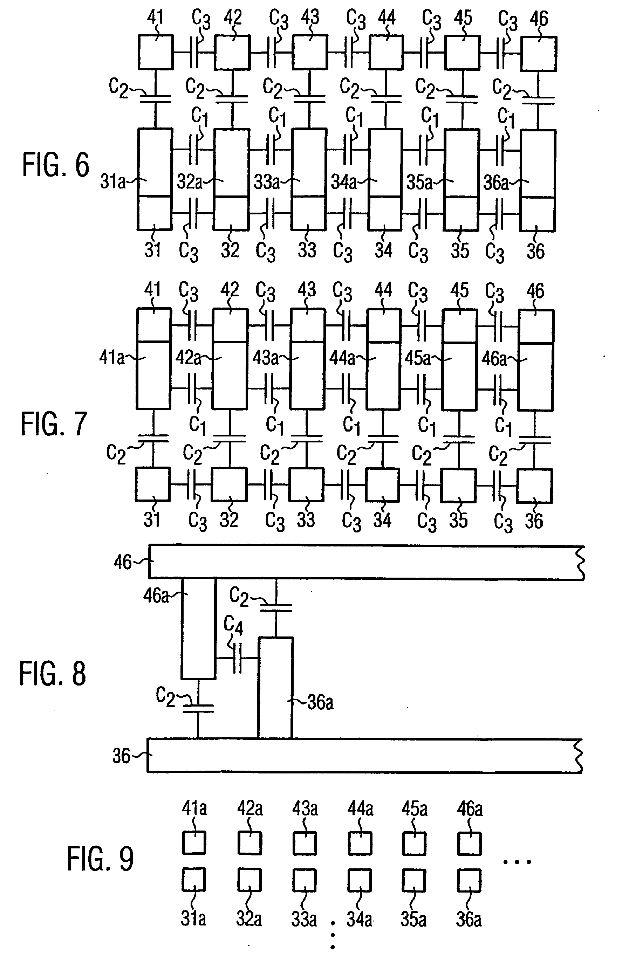

In Fig. 6 ist eine Querschnittdarstellung des zweiten Ausführungsbeispiels der Kapazitätsstruktur gemäß Fig. 5 entlang der Schnittlinie EE gezeigt. Wie zu Fig. 5 bereits ausgeführt liegen benachbarte Leitungen der Metallisierungsebenen 3 und 4 auf unterschiedlichem Potenzial. Dadurch liegen auch benachbarte, als Vias ausgebildete Stäbe 31a bis 36a und 41a bis 46a, auf unterschiedlichem Potenzial, wodurch vier Kapazitätsanteile als Beiträge zur gesamten Nutzkapazität der Kapazitätsstruktur erzeugt werden. Erste Kapazitätsanteile C₁ werden durch die gegenüberliegenden Oberflächen der Seitenbereiche zwischen den Stäben 31a bis 36a erzeugt. Ebenso werden diese Anteile C₁ durch die gegenüberliegenden Oberflächen der Seitenbereiche zwischen den Stäben 41a bis 46a, wie in Fig. 7 dargestellt ist, welche eine Schnittdarstellung der Kapazitätsstruktur gemäß Fig. 5 entlang der Schnittlinie DD zeigt, erzeugt. Zweite Kapazitätsanteile C₂ werden zwischen den gegenüberliegenden Flächenbereichen der Stäbe 31a bis 36a und den Flächenbereichen der Leitungen 41 bis 46 gebildet (Fig. 6). Gleichfalls werden diese Anteile C₂ auch durch die gegenüberliegenden Flächenbereiche der Stäbe 41a bis 46a und den Flächenbereichen der Leitungen 31 bis 36 gebildet (Fig. 7). Dritte Kapazitätsanteile C₃ werden jeweils durch die in einer Metallisierungsebene 3 und 4 benachbarten Flächenbereiche der Leitungen 31 bis 36 und 41 bis 46 gebildet (Fig. 6 und 7).

Wie in Fig. 8 anhand einer Schnittdarstellung der Kapazitätsstruktur K gemäß Fig. 5 entlang der Schnittlinie GG dargestellt ist, werden vierte Kapazitätsanteile C₄ durch die gegenüberliegenden Flächenbereiche der Stäbe 31a bis 36a der ersten Metallisierungsebene 3 zu den Stäben 41a bis 46a der zweiten Metallisierungsebene 4, beispielsweise der Stäbe 36a und 46a (Fig.8) gebildet.

In Fig. 9 ist eine Schnittdarstellung entlang der Schnittlinie FF gemäß Fig. 5 aufgezeigt. Die symmetrische Anordnung der Stäbe 31a bis 46a ist zu erkennen. Wie in der Fig. 9 angedeutet, ist die Zahl der Stäbe in beide Richtungen erweiterbar und somit auch die Anzahl der Leitungen 31 bis 46 (Fig. 5 bis 8) nicht auf die im Ausführungsbeispiel dargestellte Anzahl beschränkt.

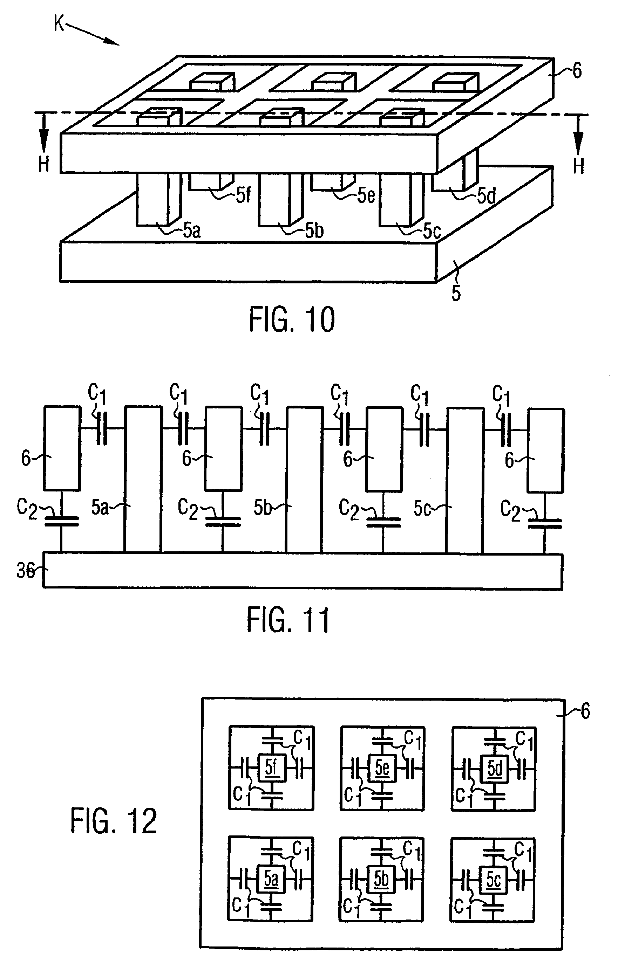

Ein weiteres Ausführungsbeispiel ist in Fig. 10 perspektivisch dargestellt. Die Kapazitätsstruktur K weist eine als zusammenhängende, vollständige Platte ausgebildete erste Metallisierungsebene 5 auf, die in einer nicht dargestellten Isolationsschicht oder einem Isolationsschichtensystem ausgebildet ist. Diese Isolationsschicht ist auf einem nicht dargestellten Halbleitersubstrat ausgebildet. Parallel zur ersten Metallisierungsebene 5 ist dazu beabstandet eine zweite Metallisierungsebene 6 in Form eines Gitters ausgebildet. Auf die erste Metallisierungsebene 5 sind stabförmig und homogen ausgebildete, elektrisch leitende Vias 5a bis 5f angeordnet, die zumindest teilweise in die Aussparungen der gitterförmigen zweiten Metallisierungsebene 6 hineinragen.

In Fig. 11 ist anhand eines Querschnitts entlang der Schnittlinie HH in Fig. 10 dargestellt welche Kapazitätsanteile C₁ und C₂ erzeugt werden und zur Nutzkapazität der Kapazitätsstruktur beitragen. Erste Kapazitätsteile C₁ werden durch die gegenüberliegenden Flächenbereiche der Vias 5a bis 5c mit der Gitterstruktur der Metallisierungsebene 6 gebildet. Zweite Kapazitätsanteile C₂ werden zwischen den gegenüberliegenden Flächenbereichen der gitterförmig ausgebildeten Metallisierungsebene 6 und der Metallisierungsebene 5 gebildet. Die gitterförmige Metallisierungsebene 6 weist eine minimale parasitäre Kapazität gegenüber dem unterhalb der ersten Metallisierungseben 5 ausgebildeten Halbleitersubstrat aus. Bei dieser Ausführungsform ist es jedoch nicht wesentlich welche der beiden Metallisierungsebenen 5 oder 6 einen minimalen parasitären Kapazitätsanteil liefert, sondern es ist wesentlich, dass die Summe der parasitären Kapazitätsanteile, die durch die Metallisierungsebenen 5 und 6 gegenüber dem Halbleitersubstrat erzeugt werden, minimal ist. Dadurch kann diese Ausführungsform auch derart ausgeführt werden, dass die gitterförmige Metallisierungsebene 6 die untere Elektrode der Kapazitätsstruktur darstellt und somit dem Hableitersubstrat näher ist als die Metallisierungsebene 5.

In Fig. 12 ist eine Draufsicht auf die Kapazitätsstruktur K gemäß Fig. 10 dargestellt. Die Vias 5a bis 5j ragen jeweils in eine der Aussparungen der Metallisierungsebene 6 und weisen nahezu gleichen Abstand zu den Rändern dieser Aussparungen auf. Wie in Fig. 12 dargestellt, wird jeweils zwischen jedem der vier gegenüberliegenden Flächenbereiche ein Kapazitätsanteil C₁ gebildet. Es kann auch vorgesehen sein, dass die Aussparungen des Gitters 6 rund oder oval und die Vias 5a bis 5f mit rundem oder ovalem Querschnitt ausgebildet werden.

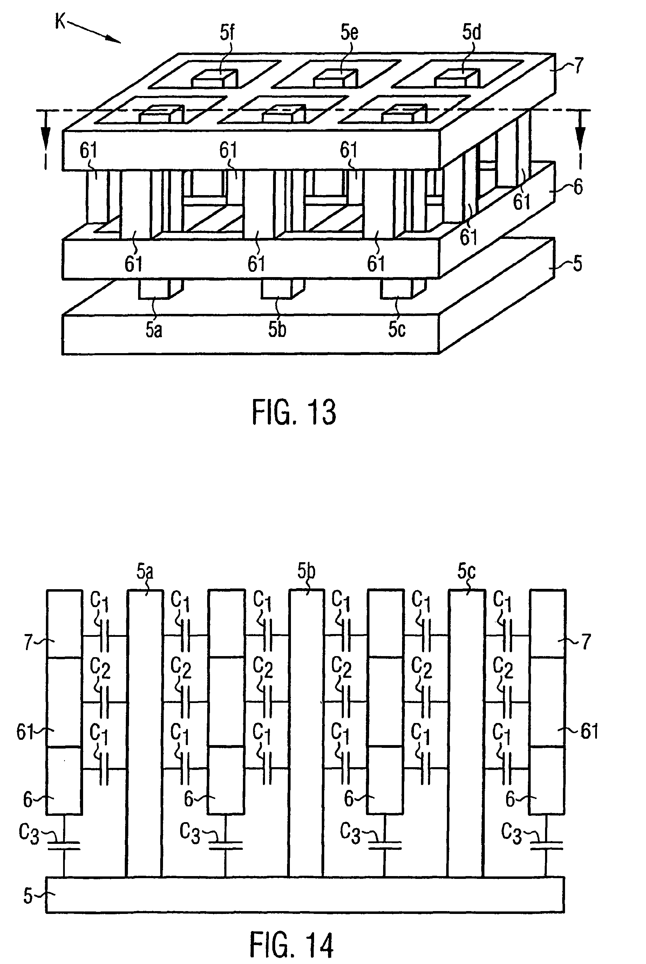

Ein Ausführungsbeispiel, welches eine Weiterführung des vorhergehenden Beispiels darstellt ist in Fig. 13 aufgezeigt. Zusätzlich zu den Metallisierungsebenen 5 und 6 weist diese Kapazitätsstruktur K eine dritte Metallisierungsebene 7 auf, die ebenfalls gitterförmig ausgebildet ist und parallel und deckungsgleich zur Metallisierungsebene 6 angeordnet ist. Die Metallisierungsebenen 6 und 7 werden durch elektrische Verbindungen 61 miteinander verbunden. Die stabförmigen elektrisch leitenden Bereiche 5a bis 5j ragen in diesem Ausführungsbeispiel durch die Aussparungen der gitterförmigen Metallisierungsebene 6 hindurch und erstrecken sich zumindest teilweise in die Aussparungen der gitterförmigen Metallisierungsebene 7.

In der Querschnittdarstellung in Fig. 14, welche die Kapazitätsstruktur K gemäß Fig. 13 entlang der Schnittlinie II zeigt, ist zu erkennen, welche Kapazitätsanteile C₁, C₂ und C₃ als Beiträge zur Nutzkapazität der Kapazitätsstruktur K geliefert werden. Erste Kapazitätsanteile C₁ werden zwischen den gegenüberliegenden Flächenbereichen der Stäbe 5a bis 5c und den gitterförmigen Metallisierungsebenen 6 und 7 gebildet. Zweite Kapazitätsanteile C₂ werden zwischen den gegenüberliegenden Flächenbereichen der Stäbe 5a bis 5c und den elektrischen Verbindungen 61 erzeugt. Des Weiteren werden dritte Kapazitätsanteile C₃ zwischen den gegenüberliegenden Flächenbereichen der Metallisierungsebene 5 und der gitterförmigen Metallisierungsebene 6 erzeugt.

Die homogenen Via-Stäbe in den Ausführungsbeispielen sind aus den bei den bekannten Prozessen verwendeten Materialien, bspw. Wolfram oder Kupfer, ausgebildet.

In allen Ausführungsbeispielen kann eine Kapazitätsstruktur K hergestellt werden, die mit relativ wenig Aufwand erzeugt werden kann und welche bei nahezu unverändertem Flächenbedarf der Kapazitätsstruktur auf der Chipfläche eine relativ große Kapazitätsoberfläche erzeugt, mit welcher das Verhältnis von Nutzkapazität zu parasitärer Kapazität verbessert wird. Insbesondere durch die homogenen - also frei von Zwischenmetallisierungbsereichen, welche beispielsweise durch Strukturierung der Metallisierungsebenen gebildet werden - Via-Stäbe, kann die Kapazitätsdichte der Kapazitätsstruktur erhöht werden.

Die Erfindung ist nicht auf die in den Ausführungsbeispielen dargestellten Kapazitätsstrukturen K beschränkt. Die Kapazitätsstruktur K kann in vielfältiger Weise ausgebildet sein. So kann beispielsweise eine Kapazitätsstruktur K eine erste Metallisierungsebene entsprechend der Metallisierungsebene 6 (Fig. 10 und 13) und eine zweite Metallisierungsebene entsprechend der Metallisierungsebene 3 (Fig. 5) aufweisen, auf denen entsprechend ausgebildete elektrisch leitenden Bereichen angeordnet sind. Es kann auch vorgesehen sein, dass eine Kapazitätsstruktur zwei gitterförmige Metallisierungsebenen entsprechend der Metallisierungsebene 6 (Fig. 10 und 13) aufweist, die derart versetzt zueinander angeordnet sind, dass die Kreuzungspunkte der Gitterstruktur der einen Metallisierungsebene vertikal unter den Aussparungen der zweiten gitterförmigen Metallisierungsebene liegen. Beide gitterförmigen Metallisierungsebenen weisen beispielsweise stabförmig ausgebildete, elektrisch leitende Bereiche auf, welche jeweils an den Kreuzungspunkten der Gitterstrukturen der Metallisierungsebenen angeordnet sind und sich in die Aussparungen der gegenüberliegenden gitterförmigen Metallisierungsebene hinein erstrecken.

## Patentansprüche

1. Halbleiterbauelement
- mit einem Halbleitersubstrat und einer auf dem Halbleitersubstrat ausgebildeten Isolationsschicht und
- mit einer Kapazitätsstruktur, welche in der Isolationsschicht ausgebildet ist, wobei die Kapazitätsstruktur mindestens zwei Metallisierungsebenen (1 bis 7) zur Erzeugung eines ersten Teils einer Kapazitätsoberfläche aufweist, welche sich im wesentlichen parallel zur Substratoberfläche erstrecken und jeweils mit einer von zwei Anschlussleitungen elektrisch verbunden sind, wobei
- die Kapazitätsstruktur mindestens einen elektrisch leitenden Bereich (1a bis 1j; 2a bis 2j; 31a bis 36a; 41a bis 46a; 5a bis 5f) aufweist, welcher zur Erzeugung eines zweiten Teils der Kapazitätsoberfläche zwischen den Metallisierungsebenen (1 bis 7) in der Isolationsschicht ausgebildet ist, und
- der elektrisch leitende Bereich (1a bis 1j; 2a bis 2j; 31a bis 36a; 41a bis 46a; 5a bis 5f) nur mit einer der Metallisierungsebenen (1 bis 7) elektrisch verbunden ist,
**dadurch gekennzeichnet, dass**
- der elektrisch leitende Bereich (1a bis 1j; 2a bis 2j; 31a bis 36a; 41a bis 46a; 5a bis 5f) als homogene, zusammenhängende Erhebung ausgebildet ist.

2. Halbleiterbauelement nach Anspruch 1,
**dadurch gekennzeichnet, dass**
der elektrisch leitende Bereich (1a bis 1j; 2a bis 2j; 31a bis 36a; 41a bis 46a; 5a bis 5f) im wesentlichen senkrecht zu den Metallisierungsebenen (1 bis 7) angeordnet ist.

3. Halbleiterbauelement nach einem der Ansprüche 1 oder 2,
**dadurch gekennzeichnet, dass**
jede der beiden Metallisierungsebenen (1, 2) als zusammenhängende Platte ausgebildet ist und mit zumindest jeweils einem elektrisch leitenden Bereich (1a bis 1j; 2a bis 2j) verbunden ist.

4. Halbleiterbauelement nach Anspruch 3,
**dadurch gekennzeichnet, dass**
die erste Metallisierungsebene (1) mit mehreren stabförmig ausgebildeten ersten elektrisch leitenden Bereichen (1a bis 1j) und die zweite Metallisierungsebene (2) mit mehreren stabförmig ausgebildeten zweiten elektrisch leitenden Bereichen (2a bis 2j) verbunden ist.

5. Halbleiterbauelement nach Anspruch 4,
**dadurch gekennzeichnet, dass**
die ersten stabförmigen, elektrisch leitenden Bereiche (1a bis 1j) mit einem festen Abstand (a) zueinander an der ersten Metallisierungsebene (1) angeordnet sind und sich in Richtung zur zweiten Metallisierungsebene (2) erstrecken und die zweiten stabförmigen, elektrisch leitenden Bereiche (2a bis 2j) mit einem festen Abstand (a) derart zueinander an der zweiten Metallisierungsebene (2) angeordnet sind, dass sie sich jeweils zwischen den ersten stabförmigen Bereichen (1a bis 1j) in Richtung zur ersten Metallisierungsebene (1) hin erstrecken.

6. Halbleiterbauelement nach Anspruch 5,
**dadurch gekennzeichnet, dass**
die ersten stabförmigen Bereiche (1a bis 1j) eine erste Länge L₁ aufweisen, die zweiten stabförmigen Bereiche (2a bis 2j) eine zweite Länge L₂, aufweisen, wobei die Länge L₂ größer, kleiner oder gleich der Länge L₁ ist, und die Summe der Längen L₁ und L₂ eines ersten und eines zweiten stabförmigen Bereichs (1a bis 1j; 2a bis 2j) größer als ein Abstand (b) zwischen den beiden Metallisierungsebenen (1, 2) ist.

7. Halbleiterbauelement nach einem der Ansprüche 1 oder 2,
**dadurch gekennzeichnet, dass**
beide Metallisierungsebenen (3, 4) jeweils aus zumindest zwei parallel zueinander angeordneten elektrischen Leitungen (31 bis 36; 41 bis 46) aufgebaut sind und die elektrischen Leitungen (31 bis 36) der ersten Metallisierungsebene (3) deckungsgleich zu den elektrischen Leitungen (41 bis 46) der zweiten Metallisierungsebene (4) angeordnet sind.

8. Halbleiterbauelement nach Anspruch 7,
**dadurch gekennzeichnet, dass**
auf jeder der ersten und zweiten elektrischen Leitungen (31 bis 36; 41 bis 46) jeweils zumindest ein elektrisch leitender Bereich (31a bis 36a; 41a bis 46a) angeordnet ist.

9. Halbleiterbauelement nach Anspruch 8,
**dadurch gekennzeichnet, dass**
mehrere stabförmig ausgebildete erste elektrisch leitende Bereiche (31a bis 36a) im festen Abstand (c) voneinander an jeder der ersten elektrischen Leitungen (31 bis 36) angeordnet sind und sich in Richtung der zweiten elektrischen Leitungen (41 bis 46) erstrecken und mehrere stabförmig ausgebildete zweite elektrisch leitende Bereiche (41a bis 46a) ebenfalls im festen Abstand (c) aber versetzt zu den ersten elektrisch leitenden Bereichen (31a bis 36a) an jeder der zweiten elektrischen Leitungen (41 bis 46) angeordnet sind und sich zwischen den ersten stabförmigen elektrisch leitenden Bereichen (31a bis 36a) in Richtung der ersten elektrischen Leitungen (31 bis 36) erstrecken.

10. Halbleiterbauelement nach Anspruch 9,
**dadurch gekennzeichnet, dass**
die stabförmigen ersten Bereiche (31a bis 36a) eine erste Länge L₁ aufweisen, die stabförmigen zweiten Bereiche (41a bis 46a) eine zweite Länge L₂, aufweisen, wobei die Länge L₂ größer, kleiner oder gleich der Länge L₁ ist, und die Summe der Längen L₁ und L₂ eines ersten und eines zweiten stabförmigen Bereichs (31a bis 36a; 41a bis 46a) größer als der Abstand (d) zwischen den elektrischen Leitungen (31 bis 36 ; 41 bis 46) ist.

11. Halbleiterbauelement nach einem der Ansprüche 1 oder 2,
**dadurch gekennzeichnet, dass**
eine der beiden Metallisierungsebenen (5) als zusammenhängende Platte und die zweite Metallisierungsebene (6) in Form eines Gitters ausgebildet ist.

12. Halbleiterbauelement nach Anspruch 11,
**dadurch gekennzeichnet, dass**
auf der als zusammenhängende Platte ausgebildeten Metallisierungsebene (5) zumindest ein stabförmig ausgebildeter, elektrisch leitender Bereich (5a bis 5f) angeordnet ist, der sich in Richtung zur zweiten gitterförmigen Metallisierungsebene (6) erstreckt und zumindest teilweise in eine Aussparung der gitterförmigen Metallisierungsebene (6) hineinragt.

13. Halbleiterbauelement nach einem der Ansprüche 11 oder 12,
**dadurch gekennzeichnet, dass**
eine gitterförmige dritte Metallisierungsebene (7) parallel und beabstandet zur zweiten Metallisierungsebene (6) auf dieser angeordnet ist und die zweite und dritte Metallisierungsebene (6, 7) mittels elektrischer Verbindungen (61) miteinander elektrisch verbunden sind.

14. Halbleiterbauelement nach Anspruch 13,
**dadurch gekennzeichnet, dass**
die stabförmigen, elektrisch leitenden Bereiche (5a bis 5f) derart ausgebildet sind, dass sie durch die Aussparungen der zweiten Metallisierungsebene (6) hindurchragen und sich zumindest teilweise in die Aussparungen der dritten Metallisierungsebene (7) hinein erstrecken.

15. Verfahren zum Herstellen eines Halbleiterbauelements, bei dem auf einem Halbleitersubstrat eine Isolationsschicht abgeschieden wird und in der Isolationsschicht eine Kapazitätsstruktur (K) erzeugt wird, wobei die Kapazitätsstruktur (K) zumindest zwei Metallisierungsebenen (1 bis 7) aufweist, die im wesentlichen parallel zur Substratoberfläche ausgebildet werden,
**dadurch gekennzeichnet, dass**
ein elektrisch leitender, homogener Bereich (1a bis 1j; 2a bis 2j; 31a bis 36a; 41a bis 46a; 5a bis 5f) in der Isolationsschicht zwischen den Metallisierungsebenen (1 bis 7) ausgebildet wird und der elektrisch leitende Bereich (1a bis 1j; 2a bis 2j; 31a bis 36a; 41a bis 46a; 5a bis 5f) nur mit einer der Metallisierungsebenen (1 bis 7) elektrisch verbunden wird.

16. Verfahren nach Anspruch 15,
**dadurch gekennzeichnet, dass**
der elektrisch leitende Bereich (1a bis 1j; 2a bis 2j; 31a bis 36a; 41a bis 46a; 5a bis 5f) als homogene zusammenhängende Erhebung ausgebildet wird, wobei der elektrische Bereich (1a bis 1j; 2a bis 2j; 31a bis 36a; 41a bis 46a; 5a bis 5f) ohne ein derartiges metallisches Gebiet ausgebildet wird, welches durch eine Strukturierung einer Metallisierungsebene (1 bis 7) erzeugbar ist

17. Verfahren nach einem der Ansprüche 15 oder 16,
**dadurch gekennzeichnet, dass**
der elektrisch leitende Bereich (1a bis 1j; 2a bis 2j; 31a bis 36a; 41a bis 46a; 5a bis 5f) in der Isolationsschicht als Via-Struktur ausgebildet wird.

18. Verfahren nach einem der Ansprüche 15 bis 17,
**dadurch gekennzeichnet, dass**
der elektrisch leitende Bereich (1a bis 1j; 2a bis 2j; 31a bis 36a; 41a bis 46a; 5a bis 5f) im wesentlichen senkrecht zu den Metallisierungsebenen (1 bis 7) ausgebildet wird.

19. Verfahren nach einem der Ansprüche 15 bis 18,
**dadurch gekennzeichnet, dass**
der elektrisch leitende Bereich (1a - 1j ; 2a - 2j; 31a - 36a; 41a - 46a; 5a - 5f) ein durch einen Damaszener-Prozess hergestelltes Gebiet ist.

## Claims

1. Semiconductor component
- having a semiconductor substrate and an insulating layer formed on the semiconductor substrate, and
- having a capacitance structure which is formed in the insulating layer, the capacitance structure having at least two metallization planes (1 to 7) for producing a first part of a capacitance surface which extend essentially parallel to the substrate surface and are each electrically connected to one of two connecting lines, where
- the capacitance structure has at least one electrically conductive region (1a to 1j; 2a to 2j; 31a to 36a; 41a to 46a; 5a to 5f) which is designed to produce a second part of the capacitance surface between the metallization planes (1 to 7) in the insulating layer, and
- the electrically conductive region (1a to 1j; 2a to 2j; 31a to 36a; 41a to 46a; 5a to 5f) is electrically connected only to one of the metallization planes (1 to 7),
**characterized in that**
- the electrically conductive region (1a to 1j; 2a to 2j; 31a to 36a; 41a to 46a; 5a to 5f) is in the form of a homogeneous, cohesive elevation.

2. Semiconductor component according to claim 1,
**characterized in that**
the electrically conductive region (1a to 1j; 2a to 2j; 31a to 36a; 41a to 46a; 5a to 5f) is arranged essentially at right angles to the metallization planes (1 to 7).

3. Semiconductor component according to one of claims 1 and 2,
**characterized in that**
each of the two metallization planes (1, 2) is in the form of a cohesive plate and is connected to at least one respective electrically conductive region (1a to 1j; 2a to 2j).

4. Semiconductor component according to claim 3,
**characterized in that**
the first metallization plane (1) is connected to a plurality of first electrically conductive regions (1a to 1j) which are in bar form, and the second metallization plane (2) is connected to a plurality of second electrically conductive regions (2a to 2j) which are in bar form.

5. Semiconductor component according to claim 4,
**characterized in that**
the first bar-like, electrically conductive regions (1a to 1j) are arranged at a fixed distance (a) from one another on the first metallization plane (1) and extend in the direction of the second metallization plane (2), and the second bar-like, electrically conductive regions (2a to 2j) are arranged at a fixed distance (a) from one another on the second metallization plane (2) such that they respectively extend between the first bar-like regions (1a to 1j) in the direction of the first metallization plane (1).

6. Semiconductor component according to claim 5,
**characterized in that**
the first bar-like regions (1a to 1j) have a first length L₁, the second bar-like regions (2a to 2j) have a second length L₂, with the length L₂ being greater than, less than or the same as the length L₁, and the sum of the lengths L₁ and L₂ of a first and of a second bar-like region (1a to 1j; 2a to 2j) is greater than a distance (b) between the two metallization planes (1, 2).

7. Semiconductor component according to one of claims 1 and 2,
**characterized in that**
the two metallization planes (3, 4) are respectively constructed from at least two electrical lines (31 to 36; 41 to 46) arranged parallel to one another, and the electrical lines (31 to 36) in the first metallization plane (3) are arranged congruently with respect to the electrical lines (41 to 46) in the second metallization plane (4).

8. Semiconductor component according to claim 7,
**characterized in that**
each of the first and second electrical lines (31 to 36; 41 to 46) respectively has at least one electrically conductive region (31a to 36a; 41a to 46a) arranged on it.

9. Semiconductor component according to claim 8,
**characterized in that**
a plurality of first electrically conductive regions (31a to 36a) which are in bar form are arranged at the fixed distance (c) from one another on each of the first electrical lines (31 to 36) and extend in the direction of the second electrical lines (41 to 46), and a plurality of second electrically conductive regions (41a to 46a) which are in bar form are likewise arranged at the fixed distance (c) but offset from the first electrically conductive regions (31a to 36a) on each of the second electrical lines (41 to 46) and extend between the first bar-like electrically conductive regions (31a to 36a) in the direction of the first electrical lines (31 to 36).

10. Semiconductor component according to claim 9,
**characterized in that**
the bar-like first regions (31a to 36a) have a first length L₁, the bar-like second regions (41a to 46a) have a second length L₂, with the length L₂ being greater than, less than or the same as the length L₁, and the sum of the lengths L₁ and L₂ of a first and of a second bar-like region (31a to 36a; 41a to 46a) is greater than the distance (d) between the electrical lines (31 to 36; 41 to 46).

11. Semiconductor component according to one of claims 1 and 2,
**characterized in that** one of the two metallization planes (5) is in the form
of a cohesive plate, and the second metallization plane (6) is in the form of a lattice.

12. Semiconductor component according to claim 11,
**characterized in that** the metallization plane (5) which is in the form of a cohesive plate has at least one electrically conductive region (5a to 5f) which is in bar form arranged on it which extends in the direction of the second
lattice-like metallization plane (6) and projects at least partially into a cutout in the lattice-like metallization plane (6).

13. Semiconductor component according to either of claims 11 and 12,
**characterized in that**
a lattice-like third metallization plane (7) is arranged parallel to and at a distance from the second metallization plane (6)
on said metallization plane (6), and the second and third metallization planes (6, 7) are electrically connected to one another by means of electrical connections (61).

14. Semiconductor component according to claim 13,
**characterized in that**
the bar-like, electrically conductive regions (5a to 5f) are in a form such that they project through the cutouts in the second metallization plane (6) and extend at least partially into the cutouts in the third metallization plane (7).

15. A method for fabricating a semiconductor component, in which an insulating layer is deposited on a semiconductor substrate, and a capacitance structure (K) is produced in the insulating layer, the capacitance structure (K) having at least two metallization planes (1 to 7) which are formed essentially parallel to the substrate surface,
**characterized in that**
an electrically conductive, homogeneous region (1a to 1j ; 2a to 2j; 31a to 36a; 41a to 46a; 5a to 5f) is formed in the insulating layer between the metallization planes (1 to 7), and the electrically conductive region (1a to 1j; 2a to 2j; 31a to 36a; 41a to 46a; 5a to 5f) is electrically connected only to one of the metallization planes (1 to 7).

16. The method according to claim 15,
**characterized in that**
the electrically conductive region (1a to 1j; 2a to 2j; 31a to 36a; 41a to 46a; 5a to 5f) is in the form of a homogeneous cohesive elevation, the electrical region (1a to 1j; 2a to 2j; 31a to 36a; 41a to 46a; 5a to 5f) being formed without such a metal area, which can be produced by patterning a metallization plane (1 to 7).

17. The method according to either of claims 15 and 16,
**characterized in that**
the electrically conductive region (1a to 1j; 2a to 2j; 31a to 36a; 41a to 46a; 5a to 5f) in the insulating layer is in the form of a via structure.

18. The method according to one of claims 15 to 17,
**characterized in that**
the electrically conductive region (1a to 1j; 2a to 2j; 31a to 36a; 41a to 46a; 5a to 5f) is formed essentially at right angles to the metallization planes (1 to 7).

19. Method according to one of claims 15 to 18, **characterized in that** the electrically conductive region (1a - 1j; 2a - 2j; 31a - 36a; 41a - 46a; 5a - 5f) is an area produced using a Damascene process.

## Revendications

1. Composant à semi-conducteur
- ayant un substrat semi-conducteur et une couche isolante constituée sur le substrat semi-conducteur et
- ayant une structure de capacité, qui est formée dans la couche isolante, la structure de capacité ayant au moins deux plans (1 à 7) de métallisation pour la production d'une première partie d'une surface de capacité, qui s'étendent sensiblement parallèlement à la surface du substrat et qui sont chacun reliés électriquement à l'une de deux lignes de connexion, dans lequel
- la structure de capacité a au moins une zone (la à 1j ; 2a à 2j ; 31a à 36a ; 41a à 46a ; 5a à 5f) conductrice de l'électricité qui est constituée pour la production d'une deuxième partie de la surface de capacité entre les plans (1 à 7) de métallisation dans la couche isolante et
- la zone (1a à 1j ; 2a à 2j ; 31a à 36a ; 41a à 46a ; 5a à 5f) conductrice de l'électricité n'est reliée électriquement qu'à l'un des plans (1 à 7) de métallisation,
**caractérisé en ce que**
- la zone (1a à 1j ; 2a à 2j ; 31a à 36a ; 41a à 46a ; 5a à 5f) conductrice de l'électricité est constituée sous la forme d'une surélévation homogène d'un seul tenant.

2. Composant à semi-conducteur suivant la revendication 1,
**caractérisé en ce que**
la zone (1a à 1j ; 2a à 2j ; 31a à 36a ; 41a à 46a ; 5a à 5f) conductrice de l'électricité est disposée sensiblement perpendiculairement aux plans (1 à 7) de métallisation.

3. Composant à semi-conducteur suivant l'une des revendications 1 ou 2,
**caractérisé en ce que**
chacun des deux plans (1, 2) de métallisation est constitué sous la forme d'une plaque d'un seul tenant et est relié à au moins respectivement une zone (1a à 1j ; 2a à 2j) conductrice de l'électricité.

4. Composant à semi-conducteur suivant la revendication 3,
**caractérisé en ce que**
le premier plan (1) de métallisation est relié à plusieurs premières zones (1a à 1j) conductrices de l'électricité constituées sous la forme de barreaux et le deuxième plan (2) de métallisation est relié à plusieurs deuxièmes zones (2a à 2j) conductrices de l'électricité constituées sous forme de barreaux.

5. Composant à semi-conducteur suivant la revendication 4,
**caractérisé en ce que**
les premières zones (1a à 1j) conductrices de l'électricité et sous forme de barreaux sont disposées à une distance (a) fixe entre elles sur le premier plan (1) de métallisation et s'étendent en direction du deuxième plan (2) de métallisation et les deuxièmes zones (2a à 2j) conductrices de l'électricité sous forme de barreaux sont disposées à une distance (a) fixe entre elles sur le deuxième plan (2) de métallisation, de façon à s'étendre, respectivement, entre les premières zones (1a à 1j) en forme de barreaux en direction du premier plan (1) de métallisation.

6. Composant à semi-conducteur suivant la revendication 5,
**caractérisé en ce que**
les premières zones (1a à 1j) en forme de barreaux ont une première longueur L₁, les deuxièmes zones (2a à 2j) en forme de barreaux ont une deuxième longueur L₂, la longueur L₂ étant supérieure, inférieure ou égale à la longueur L₁ et la somme des longueurs L₁ et L₂ d'une première zone (1a à 1j) en forme de barreau et d'une deuxième zone (2a à 2j) en forme de barreau étant plus grande qu'une distance (b) entre les deux plans (1, 2) de métallisation.

7. Composant à semi-conducteur suivant l'une des revendications 1 ou 2,
**caractérisé en ce que**
les deux plans (3, 4) de métallisation sont constitués, respectivement, d'au moins deux lignes (31 à 36 ; 41 à 46) électriques disposées parallèlement l'une à l'autre et les lignes (31 à 36) électriques du premier plan (3) de métallisation sont disposées en coïncidence avec les lignes (41 à 46) électriques du deuxième plan (4) de métallisation.

8. Composant à semi-conducteur suivant la revendication 7,
**caractérisé en ce que**
au moins une zone (31a à 36a ; 41a à 46a) électrique est disposée, respectivement, sur chacune des premières et deuxièmes lignes (31 à 36 ; 41 à 46) électriques.

9. Composant à semi-conducteur suivant la revendication 8,
**caractérisé en ce que**
plusieurs premières zones (31a à 36a) conductrices de l'électricité et constituées sous la forme de barreaux sont disposées à une distance (c) fixe les unes des autres sur chacune des premières lignes (31 à 36) électriques et s'étendent en direction des deuxièmes lignes (41 à 46) électriques et plusieurs deuxièmes zones (41a à 46a) conductrices de l'électricité et constituées sous la forme de barreaux sont également disposées à une distance (c) fixe, mais en étant décalées par rapport aux premières zones (31a à 36a) conductrices de l'électricité, sur chacune des deuxièmes lignes (41 à 46) électriques et s'étendent entre les premières zones (31a à 36a) conductrices de l'électricité et en forme de barreaux en direction des premières lignes (31 à 36) électriques.

10. Composant à semi-conducteur suivant la revendication 9,
**caractérisé en ce que**
les premières zones (31a à 36a) en forme de barreaux ont une première longueur L₁, les deuxièmes zones (41a à 46a) en forme de barreaux ont une deuxième longueur L₂, la longueur L₂ étant supérieure, inférieure ou égale à la longueur L₁ et la somme des longueurs L₁ et L₂ d'une première zone (31a à 36a) et d'une deuxième zone (41a à 46a) en forme de barreaux étant plus grande que la distance (d) entre les lignes (31 à 36 ; 41 à 46) électriques.

11. Composant à semi-conducteur suivant l'une des revendications 1 ou 2,
**caractérisé en ce que**
l'un des deux plans (5) de métallisation est constitué sous la forme d'une plaque d'un seul tenant et le deuxième plan (6) de métallisation sous la forme d'une grille.

12. Composant à semi-conducteur suivant la revendication 11,
**caractérisé en ce que**
sur le plan (5) de métallisation constitué sous la forme d'une plaque d'un seul tenant est disposée au moins une zone (5a à 5f) conductrice de l'électricité en forme de barreau qui s'étend en direction du deuxième plan (6) de métallisation en forme de grille et qui pénètre au moins en partie dans un évidement du plan (6) de métallisation en forme de grille.

13. Composant à semi-conducteur suivant l'une des revendications 11 ou 12,
**caractérisé en ce que**
un troisième plan (7) de métallisation en forme de grille est disposé parallèlement et à distance du deuxième plan (6) de métallisation sur celui-ci et les deuxième et troisième plans (6, 7) de métallisation sont reliés électriquement entre eux au moyen de liaisons (61) électriques.

14. Composant à semi-conducteur suivant la revendication 13,
**caractérisé en ce que** les zones (5a à 5f) conductrices de l'électricité et en forme de barreaux sont telles qu'elles passent dans les évidements du deuxième plan (6) de métallisation et s'étendent, au moins en partie, dans les évidements du troisième plan (7) de métallisation.

15. Procédé de production d'un composant à semi-conducteur, dans lequel on dépose une couche isolante sur un substrat semi-conducteur et l'on produit une structure (K) de capacité dans la couche isolante, la structure (K) de capacité ayant au moins deux plans (1 à 7) de métallisation, qui sont constitués en étant sensiblement parallèles à la surface du substrat,
**caractérisé en ce que**
l'on forme une zone (1a à 1j ; 2a à 2j ; 31a à 36a ; 41a à 46a ; 5a à 5f) homogène et conductrice de l'électricité dans la couche isolante entre les plans (1 à 7) de métallisation et on relie électriquement la zone (1a à 1j ; 2a à 2j ; 31a à 36a ; 41a à 46a ; 5a à 5f) conductrice de l'électricité seulement à l'un des plans (1 à 7) de métallisation.

16. Procédé suivant la revendication 15,
**caractérisé en ce que**
l'on forme la zone (1a à 1j ; 2a à 2j ; 31a à 36a ; 41a à 46a ; 5a à 5f) conductrice de l'électricité sous la forme d'une surélévation homogène d'un seul tenant, la zone (1a à 1j ; 2a à 2j ; 31a à 36a ; 41a à 46a ; 5a à 5f) conductrice de l'électricité étant formée sans région métallique telle qu'elle puisse être produite par une structuration d'un plan (1 à 7) de métallisation.

17. Composant à semi-conducteur suivant l'une des revendications 15 ou 16,
**caractérisé en ce que**
l'on forme la zone (1a à 1j ; 2a à 2j ; 31a à 36a ; 41a à 46a ; 5a à 5f) conductrice de l'électricité dans la couche isolante sous la forme d'une structure via.

18. Composant à semi-conducteur suivant l'une des revendications 15 à 17,
**caractérisé en ce que**
l'on forme la zone (1a à 1j ; 2a à 2j ; 31a à 36a ; 41a à 46a ; 5a à 5f) conductrice de l'électricité sensiblement perpendiculairement aux plans (1 à 7) de métallisation.

19. Composant à semi-conducteur suivant l'une des revendications 15 à 18,
**caractérisé en ce que**
la zone (1a à 1j ; 2a à 2j ; 31a à 36a ; 41a à 46a ; 5a à 5f) conductrice de l'électricité est un domaine produit par un processus Damascène.
